# NEUE EUROPÄISCHE PATENTSCHRIFT

(11) **EP 3 798 158 B2**
(45) Veröffentlichungstag und Bekanntmachung des Hinweises auf die Entscheidung über den Einspruch: **05.08.2026**
(45) Hinweis auf die Patenterteilung: 15.11.2023
(21) Anmeldenummer: 20192281.2
(22) Anmeldetag: 21.08.2020
(51) Int. Cl.: B65G 37/00, B67C 3/24, B67C 7/00, B41J 3/407, B05D 7/22, B65G 37/02, B65G 47/86, B67C 3/22, B65G 54/02

(54) **MODULAR AUFGEBAUTE BEHANDLUNGSVORRICHTUNG FÜR BEHÄLTNISSE**
MODULAR TREATMENT DEVICE FOR CONTAINERS
DISPOSITIF DE MANIPULATION DE CONCEPTION MODULAIRE POUR RÉCIPIENTS

(30) Priorität: 30.09.2019 DE 102019126289
(43) Veröffentlichungstag der Anmeldung: 31.03.2021
(73) Patentinhaber: KRONES AG, 93073 Neutraubling (DE)
(72) Erfinder: Domeier, Bernhard, 93073 Neutraubling (DE); Böttcher, Benedikt, 93073 Neutraubling (DE); Handschuh, Eduard, 93073 Neutraubling (DE); Voth, Klaus, 93073 Neutraubling (DE)
(74) Vertreter: Hannke Bittner & Partner mbB Regensburg

(56) Entgegenhaltungen:
- EP-A1- 1 787 662
- EP-A1- 1 954 851
- EP-A1- 3 798 158
- EP-A2- 2 689 933
- EP-A2- 2 689 933
- EP-A2- 3 239 079
- WO-A1-03/100125
- WO-A1-2015/036197
- DE-A1- 10 234 374
- DE-A1- 102007 017 646
- DE-A1- 102012 112 946
- US-A1- 2013 026 005
- US-B1- 9 873 569

## Beschreibung

Die vorliegende Erfindung betrifft die Beschichtung der Innenwandung von Kunststoffbehältnissen. Es wird jedoch darauf hingewiesen, dass die hier beschriebene Offenbarung auch auf andere verschiedene Typen zum Behandeln von Behältnissen, wie beispielsweise Sterilisationseinrichtungen, anwendbar ist. Allerdings ergeben sich durch bevorzugte Ausgestaltungen der Erfindung Vorteile, die insbesondere auch für Beschichtungseinrichtungen anwendbar sind.

Aus dem Stand der Technik ist eine Beschichtungseinrichtung bekannt, welche einen Zuführstern aufweist, sowie ein Trägerrad, auf dem eine Vielzahl von Beschichtungsstationen angeordnet ist, welche die Behältnisse gleichzeitig transportieren und beschichten. Diese Vorrichtungen bringen gewisse Nachteile mit sich. Einerseits ist eine Wartung einzelner Beschichtungsstationen nicht möglich, ohne hierzu die gesamte Anlage anzuhalten.

Weiterhin erlauben derartige Anlagen auch keine Erweiterung deren Kapazität bzw. eine variable Anpassung der Kapazität.

Aus der EP 2 689 933 A1 ist beispielsweise ein System zur Ausstattung von Behältern mit wenigstens zwei Ausstattungsvorrichtungen bekannt, wobei jede Ausstattungseinrichtung ein modular aufgebautes Transportsystem aufweisen kann.

Die US 9,873,569 B1 beschreibt eine Maschine zur Behandlung von Behältern, wobei Behandlungsmodule aus ihren Betriebspositionen herausgenommen werden können, so dass die Maschine an unterschiedliche Behandlungsprozesse angepasst oder hinsichtlich des Durchsatzes erweitert werden kann

Aus der DE 10 2007 017 646 A1 ist eine Verpackungsmaschine mit mehreren Arbeitsstationen bekannt, wobei die Verpackungsmaschine aus mehreren, lösbar miteinander gekoppelten Modulen aufgebaut ist.

Weiterhin ist aus der US 2013/026005 A1 eine Transporteinrichtung bekannt, welche Behälter von der ersten Behälterbehandlungsvorrichtung zu der zweiten Behälterbehandlungsvorrichtung transportiert, und mindestens ein bewegbar an der Transportbahn gelagertes Transportelement aufweist.

Die EP 1 787 662 A1 beschreibt weiter eine modulare Wasch- und Sterilisationsanlage

Der vorliegenden Erfindung liegt daher die Aufgabe zugrunde, eine Vorrichtung und ein Verfahren vorzuschlagen, welche insbesondere auch eine variable Erweiterbarkeit derartiger Anlagen ermöglichen. Dies wird erfindungsgemäß durch den Gegenstand des Anspruchs 1 erreicht. Vorteilhafte Ausführungsformen und Weiterbildungen sind Gegenstand der Unteransprüche.

Eine Vorrichtung zum Behandeln von Behältnissen und insbesondere Kunststoffbehältnissen weist eine Behältnisbehandlungseinheit auf, wobei die Vorrichtung eine Haupttransporteinrichtungen aufweist, welche dazu geeignet und bestimmt ist, die Behältnisse entlang eines vorgegebenen Transportpfades zu transportieren, und wobei die erste Behälterbehandlungseinheit wenigstens eine Behandlungseinrichtung und bevorzugt wenigsten zwei Behandlungseinrichtungen aufweist, welche dazu geeignet und bestimmt sind, die Behältnisse in einer vorgegebenen Weise zu behandeln.

Weiterhin weist die Vorrichtung eine Zuführ- und Abführeinheit auf, welche dazu geeignet und bestimmt ist, wenigstens der ersten Behältnisbehandlungseinheit zu behandelnde Behältnisse zuzuführen und von der ersten Behältnisbehandlungseinheit behandelte Behältnisse abzuführen. Daneben weist die Vorrichtung eine Medienversorgungseinheit auf, welche dazu geeignet und bestimmt ist, der wenigstens ersten Behandlungseinrichtung Medien zuzuführen und/oder von der ersten Behandlungseinrichtung ein Medium wie insbesondere Luft abzuführen.

Die Vorrichtung ist modular aufgebaut und bevorzugt beliebig erweiterbar und oder veränderbar und es ist wenigstens eine weitere Behältnisbehandlungseinrichtung hinzufügbar, welche die Behältnisse in der vorgegebenen Weise behandelt und welche bevorzugt eine Transporteinrichtung aufweist, welche dazu geeignet und bestimmt ist, die Behältnisse entlang eines vorgegebenen Transportpfades zu transportieren, sowie wenigstens zwei Behandlungsstationen, welche dazu geeignet und bestimmt sind, die Behältnisse in einer vorgegebenen Weise zu behandeln.

Eine erfindungsgemäße Vorrichtung zum Beschichten von Behältnissen und insbesondere Kunststoffbehältnissen weist eine Behälterbehandlungseinheit auf, wobei die Vorrichtung eine Haupttransporteinrichtung aufweist, welche dazu geeignet und bestimmt ist, die Behältnisse entlang eines vorgegebenen Transtransportpfads zu transportieren, wobei die Behältnisbehandlungseinheit wenigstens zwei Beschichtungseinrichtungen zum Beschichten von Wandungen der Behältnisse aufweist, welche dazu geeignet und bestimmt sind, die Behältnisse in einer vorgegebenen Weise zu beschichten. Die Vorrichtung weist weiterhin eine Zuführ- und Abführeinheit auf, welche dazu geeignet und bestimmt ist, wenigstens der ersten Behandlungseinheit zu behandelnde Behältnisse zuzuführen und von der ersten Behandlungseinheit behandelte Behältnisse abzuführen und mit einer Medienversorgungseinheit, welche dazu geeignet und bestimmt ist, der wenigstens einen ersten Behandlungseinheit Medien zuzuführen

Erfindungsgemäß ist die Vorrichtung modular aufgebaut und/oder beliebig erweiterbar, derart dass wenigstens eine weitere Behältnisbeschichtungseinrichtung hinzufügbar ist, welche eine Behandlungstransporteinrichtung aufweist, welche dazu geeignet und bestimmt ist, die Behältnisse entlang eines vorgegebenen Transtransportpfads zu transportieren, mit wenigstens zwei Beschichtungsmodulen, welche dazu geeignet und bestimmt sind, die Behältnisse in der vorgegebenen Weise zu beschichten.

Es wird also vorgeschlagen, dass die Anlage modular aufgebaut und/oder beliebig erweiterbar ist und durch weitere Behandlungseinrichtungen ergänzt werden kann, um auf diese Weise beispielsweise die Kapazität zu erhöhen.

Im Folgenden wir der Begriff Vorrichtung zum Behandeln von Behältnissen für die Gesamte Anlage verwendet. Diese Vorrichtung weist eine Behandlungseinheit auf, welche wiederum eine oder mehrere Behandlungseinrichtungen aufweisen kann. Die Behandlungseinrichtungen wiederum weisen eine Vielzahl von Behandlungsstationen auf. Diese Behandlungseinrichtungen weisen wie oben erwähnt ebenfalls jeweils eine Transporteinrichtung auf, welche die Behältnisse den einzelnen Behandlungsstationen zuführen.

Damit ist insbesondere die Anzahl der Behandlungseinrichtungen veränderbar und/oder anpassbar.

Bevorzugt ist die Haupttransporteinrichtung wenigstens hinsichtlich einer Eigenschaft anpassbar, insbesondere um die Vorrichtung an unterschiedliche Anzahlen von Behandlungseinrichtungen anzupassen. So kann beispielsweise die Aufnahmekapazität der Haupttransporteinrichtung hinsichtlich der Behältnisse angepasst werden und/oder eine Transportlänge der Haupttransporteinrichtung.

Bei einer weiteren bevorzugten Ausführungsform ist die Haupttransporteinrichtung segmentartig aufgebaut und auf diese Weise insbesondere an eine unterschiedliche Anzahl von Behandlungseinrichtungen anpassbar.

Insbesondere handelt es sich bei der ersten Behältnisbehandlungseinrichtung und der zweiten Behältnisbehandlungseinrichtung um gleichartige Einrichtungen, welche im Wesentlichen die gleichen Behandlungsvorgänge, wie Beschichtungsvorgänge durchführen.

Bei einer weiteren bevorzugten Ausführungsform werden jeweils die Zu- und Abführeinheit einerseits und die Medienversorgungseinheit andererseits beibehalten. Insbesondere kann es sich bei den Medien beispielsweise um Chemikalien handeln, mit denen die Kunststoffbehältnisse versorgt werden. Auch kann es sich bei dem Medium um "einen Unterdruck" handeln, das heißt, in diesem Falle versorgt die Medienversorgungseinheit die Behältnisse mit einem Unterdruck bzw. es wird Luft aus den Behältnissen abgeführt. Im Rahmen der vorliegenden Anmeldung werden daher unter Medien insbesondere Substanzen verstanden, nicht jedoch etwa elektrische Energie.

Die Behandlungseinrichtungen selbst können wahlweise an die Haupttransporteinrichtung angekoppelt werden, um so die Produktionsleistung der Anlage verändern zu können. Bei einer weiteren bevorzugten Ausführungsform transportiert die Haupttransporteinrichtung die Behältnisse kontinuierlich. Die Zu- und Abführungseinheit führt die Behältnisse insbesondere der Haupttransporteinrichtung zu.

Bei einer weiteren bevorzugten Ausführungsform ist die Behandlungseinheit räumlich zwischen der Versorgungseinheit und der Medienversorgungseinheit angeordnet. Auf diese Weise kann ein besonders effizientes Systemlayout erreicht werden.

Dabei kann beispielsweise eine Frontseite vorgesehen sein, welche eine Anzeigeeinrichtung und insbesondere ein Touch Panel aufweist.

Die Zuführ- und Abführeinheit kann dabei beispielsweise einen oder auch zwei oder auch mehrere Transportsterne aufweisen, welche dazu dienen, die Behältnisse der Haupttransporteinrichtung zuzuführen.

Bei einer weiteren bevorzugten Ausführungsform ist die Zu- und Abführeinheit auch dazu geeignet und bestimmt, der weiteren Behandlungseinrichtung zu behandelnde Behältnisse zuzuführen und von der weiteren Behandlungseinrichtung behandelte Behältnisse abzuführen. Dies bedeutet, dass die Zu- und Abführeinheit auch zum Versorgen der weiteren Behandlungseinrichtung dient.

Bei einer weiteren bevorzugten Ausführungsform ist die Medienversorgungseinheit dazu bestimmt, der weiteren Behandlungseinrichtung Medien zuzuführen, wobei, wie oben erwähnt, bei dem Medium auch eine Vakuumbeaufschlagung verstanden werden kann, das heißt, im physikalischen Sinne die Entnahme eines Mediums - nämlich von Luft.

Bei einer weiteren bevorzugten Ausführungsform ist die Medienversorgungseinheit dazu geeignet und bestimmt, den Behandlungseinrichtungen mehrere und/oder unterschiedliche Medien zuzuführen.

Bei einer weiteren vorteilhaften Ausführungsform sind die Behältnisbehandlungseinrichtungen bezüglich des Transportpfades der Behältnisse in Serie und/oder parallel geschalten. Dies bedeutet, dass mehrere derartige Behandlungseinrichtungen entlang des Transportpfads der Behältnisse hintereinander angeordnet sein können. Im Falle eines parallelen Transports kann ein Transportpfad in zwei Teilpfade aufgespalten werden.

Bei einer weiteren bevorzugten Ausführungsform weist die Behandlungseinrichtung eine Behandlungstransporteinrichtung auf, welche die Behältnisse transportiert und wobei die Behältnisse von der Haupttransporteinrichtung an eine der Behandlungseinrichtungen zum Zwecke der Behandlung durch die Behandlungseinrichtung übergebbar sind, und die Behältnisse insbesondere nach deren Behandlung durch die Behandlungseinrichtung wieder an die Haupttransporteinrichtung übergebbar sind. Bei dieser Behältnistransporteinrichtung kann es sich beispielsweise um einen bewegbaren und/oder drehbaren Träger handeln.

Bei einer weiteren bevorzugten Ausführungsform ist die Behandlungstransporteinrichtung dazu geeignet und bestimmt, die Behältnisse getaktet zu transportieren. Bei einer weiteren bevorzugten Ausführungsform sind einzelne Behandlungsstationen der Behandlungseinheit stationär ausgebildet. Dies bedeutet, dass besonders bevorzugt der Behandlungsvorgang, beispielsweise ein Beschichtungsvorgang in einem stehenden Zustand der Behältnisse (bezüglich des Transportpfads) durchgeführt wird. Auch hier ist es wieder möglich, dass von der Haupttransporteinrichtung eine Vielzahl von Behältnissen abgenommen wird, und diese anschließend zu stehenden Behandlungsstationen geführt werden und dort behandelt, beispielsweise beschichtet, werden. Wie oben erwähnt ist die Haupttransporteinrichtung insbesondere dazu geeignet und bestimmt, die Behältnisse kontinuierlich zu transportieren.

Bei einer bevorzugten Ausführungsform kann die Behandlungseinrichtung wenigstens drei, bevorzugt wenigstens vier Behandlungsstationen aufweisen. Bevorzugt weist die Behandlungseinrichtung höchstens 20, bevorzugt höchstens 18, bevorzugt höchstens 16, bevorzugt höchstens 14 und bevorzugt höchstens 10 Behandlungsstationen auf.

Erfindungsgemäß sind die Behandlungseinrichtungen Beschichtungseinrichtungen zum Beschichten von Innenwandungen für Behältnisse, Bei den Behältnissen handelt es sich, wie oben erwähnt, insbesondere um Kunststoffbehältnisse, es wäre jedoch auch die Beschichtung von Glasbehältnissen denkbar.

Erfindungsgemäß weist die Vorrichtung eine Behältniswendeeinrichtung auf, die dazu geeignet und bestimmt ist, die zu transportierenden Behältnisse zu wenden. So ist erfindungsgemäß vorgesehen, dass der Zu- und Abführreinrichtung die Behältnisse mit ihrer Mündung nach oben zugeführt werden, jedoch der eigentliche Behandlungsvorgang in einem gewendeten Zustand der Behältnisse, das heißt, ein Zustand, in dem die Mündung der Behältnisse nach unten ragt (das heißt näher der Erdmittelpunkt ist) erfolgt.

Bei einer bevorzugten Ausführungsform ist die besagte Behältniswendeeinrichtung ein Bestandteil der Zu- und Abführeinheit. Das heißt, bei einer Erweiterung der Anlage wird diese Wendeeinrichtung beibehalten und bevorzugt nicht modifiziert. Es ist jedoch ebenso möglich, dass die Behältniswendeeinrichtung nicht Bestandteil der Zuführ- und Abführeinheit ist, sondern führt dieser die Behältnisse lediglich zu.

So ist es beispielsweise möglich, dass die Wendeeinrichtung ebenfalls als ein Umlauf- und Transportmittel, wie etwa eine umlaufende Kette ausgebildet ist. Diese kann dabei bevorzugt auch horizontal angeordnet sein und so ein Wenden der Behältnisse ermöglichen.

Auch wäre es möglich, dass die Wendeeinrichtung eine linearmotorische Antriebseinrichtung aufweist und insbesondere einen Langstator, der besonders bevorzugt ebenfalls horizontal angeordnet ist. So wäre es möglich, dass eine Kette oder ein derartiger Langstator, beispielsweise oval ausgeführt ist, und räumlich beispielsweise wie eine Fahrzeugkette beispielsweise eine Panzerkette verläuft. Auf diese Weise ist in besonders einfacher Weise ein Wenden der Behältnisse möglich.

Bei einer weiteren bevorzugten Ausführungsform weist die Vorrichtung eine Teilungsänderungseinrichtung auf, welche dazu geeignet und bestimmt ist, einen Abstand zweier in der Transporteinrichtung hintereinander angeordneter Behältnisse zu verändern. Dabei kann auch diese Teilungsänderungseinrichtung ein Bestandteil der oben erwähnten Zu- und Abführeinheit sein.

Bei einer weiteren bevorzugten Ausführungsform ist wenigstens eine Behandlungseinrichtung und/oder Behandlungsstation und sind bevorzugt sämtliche Behandlungseinrichtungen und/oder die Behandlungsstationen senkrecht bezüglich eines Transportpfads der Behältnisse angeordnet. So kann es beispielsweise sein, dass diese Behandlungseinheit oberhalb oder unterhalb des Transportpfads der Behältnisse angeordnet sind. Dabei ist es weiterhin möglich, dass sich wenigstens ein Behandlungselement, im Wesentlichen senkrecht bezüglich des Transportpfads der Behältnisse bewegt. Dabei kann es sich beispielsweise um ein Element handeln, welches sich durch eine Mündung der Behältnisse in diese Behältnisse einführbar ist.

So kann beispielsweise ein Beschichtungsmodul in einem rechten Winkel zu der genannten Transferstrecke angeordnet sein.

Bei einer weiteren bevorzugten Ausführungsform weisen die Behandlungseinrichtungen in Form von Beschichtungseinrichtungen jeweils (Gas)Lanzen auf, die in die Behältnisse einführbar sind. Weiterhin weisen die Behandlungseinrichtungen auch Zündeinrichtungen wie insbesondere Zündelektroden auf. Bevorzugt bilden dabei eine Gaslanze und wenigstens eine Zündelektrode eine eigenständige Einheit.

Weiterhin sind auch Medienzuführungen vorgesehen, um der besagten Gaslanze Beschichtungsmedien zuzuführen.

Bevorzugt weist damit die Behandlungseinrichtung ein längliches, stabförmiges Element, insbesondere eine Lanze auf. Bevorzugt weist diese Lanze Öffnungen auf. Durch diese Öffnungen kann bevorzugt ein fließfähiges Medium in die Behältnisse eingeleitet werden. Bevorzugt handelt es sich bei diesem fließfähigen Medium um ein für den Plasmaprozess geeignetes Gas. Vorteilhaft kann es sich bei diesem Gas um ein Gemisch aus einem siliziumhaltigen Präkursor und Sauerstoff handeln, insbesondere für eine PECVD (=plasma enhanced chemical vapor deposition) mit Siliziumoxid. Es sind jedoch auch andere Gase denkbar, zum Beispiel Acetylen für die Abscheidung von sog. DLC-Schichten. Für eine Plasmasterilisation können z.B. Argon und Wasserdampf in die Behälter eingeleitet werden.

Bei einer weiteren bevorzugten Ausführungsform weist die Beschichtungseinrichtung bzw. weisen die Beschichtungsmodule Vakuumpumpen auf. Daneben sind auch Antriebe vorgesehen, die etwa eine Lanze in die Behältnisse bewegen. Bevorzugt können bei einer Beschichtungsvorrichtung Vakuumpumpen, Antriebe für Beschichtungslanzen und Pumpen für das Beschichtungsgas ausgeschaltet werden.

Bei einer weiteren bevorzugten Ausführungsform transportiert wenigstens eine Transporteinrichtung und insbesondere die Haupttransporteinrichtung die Behältnisse wenigstens abschnittsweise entlang eines Transportpfades, der von einem kreissegmentförmigen Verlauf abweicht bzw. einen von einem kreissegmentförmigen abweichenden Verlauf hat. Während in dem Stand der Technik üblicherweise Transporträder eingesetzt werden, wird hier vorgeschlagen, dass der Transportpfad einen unterschiedlichen Krümmungsverlauf aufweist. So kann der Transportpfad beispielsweise gerade Abschnitte aufweisen oder auch gekrümmte Abschnitte.

Bevorzugt kann dieser Transportpfad in der Art eines Ovals ausgebildet sein, das heißt mit zwei geraden Streckenabschnitten und zwei Umlenkungsbereichen.

Bei einer weiteren bevorzugten Ausführungsform weist wenigstens eine Transporteinrichtung ein umlaufendes Transportmittel und insbesondere eine Transportkette oder einen Langstator auf.

Dabei ist besonders bevorzugt dieses Transportmittel horizontal ausgerichtet.

Weitere Vorteile und Ausführungsformen ergeben sich aus den beigefügten Zeichnungen. Darin zeigen:
- Fig. 1: Eine schematische Darstellung zur Veranschaulichung des der Erfindung zugrundeliegenden Konzepts;
- Fig. 2: Eine erfindungsgemäße Vorrichtung;
- Fig. 3: Eine Seitenansicht der in Figur 2 gezeigten Vorrichtung;
- Fig. 4: Eine perspektivische Darstellung der in Figur 2 gezeigten Vorrichtung;
- Fig. 5: Eine weitere Darstellung zur Veranschaulichung des der Erfindung zugrunde liegenden Konzepts;
- Fig. 6: Eine Darstellung einer Vorrichtung mit einer höheren Anzahl an Behandlungseinrichtungen;
- Fig. 7: Eine Darstellung zur Veranschaulichung einer Vorrichtung mit einer weiter erhöhten Anzahl von Bearbeitungseinrichtungen;
- Fig. 8a - 8e: Mehrere Aufbaukonzepte für erfindungsgemäße Vorrichtung;
- Fig. 9: Eine Darstellung zur Veranschaulichung des Transports der Behältnisse;
- Fig. 10: Eine perspektivische Darstellung zur Veranschaulichung des Transports und des Wendens der Behältnisse;
- Fig. 11-26: unterschiedliche Ausgestaltungen von erfindungsgemäßen Behandlungseinrichtungen.

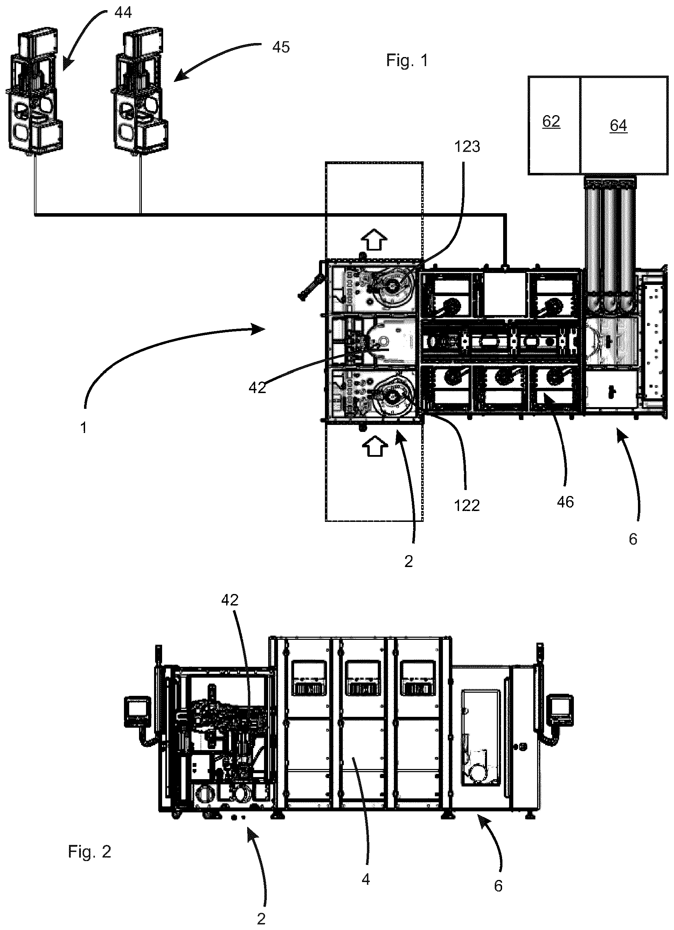

Figur 1 zeigt eine Darstellung zur Veranschaulichung der Erfindung. Dabei bezieht sich das Bezugszeichen 1 auf die Vorrichtung in ihrer Gesamtheit. Diese weist eine Zu- und Abführeinheit 2 für die Behältnisse auf. Diese Zu- und Abführeinheit kann dabei eine erste Transporteinrichtung 122, insbesondere einen ersten Transportstern 122 und eine zweite Transporteinrichtung 123, insbesondere einen zweiten Transportstern 123 aufweisen. Mittels des ersten Transportsterns werden der Vorrichtung die Behältnisse zugeführt und mittels der zweiten Transporteinrichtung 123 werden die (gegebenenfalls bereits behandelten Behältnisse) abgeführt.

Das Bezugszeichen 42 kennzeichnet eine Haupttransporteinrichtung, welche einerseits die Behältnisse von einem Transportstern 122 übernimmt und sie wiederum an einen Transportstern 123 abgibt. Diese Haupttransporteinrichtung ragt auch in die Zu- und Abführeinheit 2 und erstreckt sich in eine Behältnisbehandlungseinheit 4. Von dieser Haupttransporteinrichtung 42 können die Behältnisse zum Zweck Ihrer Behandlung von den einzelnen Behandlungseinrichtungen abgenommen werden.

Zu diesem Zweck weist die Haupttransporteinrichtung 42 eine Vielzahl von Halteelementen auf, welche zum Halten der einzelnen Behältnisse und zu deren Transport dienen. Bevorzugt werden dabei die Behältnisse in Reihe transportiert.

Auch der Zuführstern 122 und der Abführstern 123 weisen eine Vielzahl von Halteeinrichtungen auf, um die Behältnisse vereinzelt zu transportieren.

Weiterhin ist es auch möglich, dass eine der oder beide Transporteinrichtungen 122, 123 als sogenannte Teilungsverzugseinrichtung ausgebildet ist, welche dazu geeignet und bestimmt ist, eine Teilung bzw. einen Abstand der transportierten Behältnisse zu verändern. So können beispielsweise unterschiedliche Teilungen eingestellt werden.

Die Haupttransporteinrichtung 42 kann dabei als eine umlaufende Kette ausgebildet sein, an der die einzelnen Halteeinrichtungen zum Halten der Behältnisse angeordnet sind. Es wäre jedoch auch möglich, dass die Haupttransporteinrichtung wie oben erwähnt als Langstator ausgebildet ist bzw. als linearmotorischer Antrieb.

Die Bezugszeichen 44, 45 und 46 kennzeichnen einzelne Behandlungsstationen. Diese Behandlungseinrichtungen 44, 45, 46 weisen jeweils wiederum eine Behältnistransporteinrichtung 44b, 45b, 46b auf, wie etwa einen drehbaren Träger, der zum Transportieren der Behältnisse in die jeweiligen Behandlungsstationen dienen. Die Behandlungsstationen selbst sind bevorzugt stationär angeordnet, das heißt die Behältnisse werden diesen zur Behandlung übergeben. Bevorzugt transportieren diese einzelnen Behältnistransporteinrichtungen die Behältnisse getaktet.

Das Bezugszeichen 6 kennzeichnet eine Medienversorgungseinheit. Diese kann einerseits die Behältnisse mit einem Unterdruck bzw. einem Vakuum versorgen und auch beispielsweise mit einem Plasma zu deren Beschichtung. Zu diesem Zweck bezeichnet das Bezugszeichen 62 einen Vakuumpumpenstand und das Bezugszeichen 64 einen Chemikalienstand.

Wie einzeln erwähnt, kann die Anzahl und die Anordnung der Behältnisbehandlungseinrichtungen 44, 45, 46 verändert werden, um auf diese Weise die Produktionskapazität der Anlage verändern zu können.

Bevorzugt ist es auch möglich, dass die Haupttransporteinrichtung 42 modular aufgebaut ist, sodass beispielsweise der Transportpfad der Haupttransporteinrichtung 42 verändert werden kann. Zu diesem Zweck können beispielsweise beim Vorsehen einer Kette mehrere Module eingeführt werden und eine entsprechende Transportkette ebenfalls erweitert werden. Falls die Haupttransporteinrichtung einen Langstator aufweist, können auch hier zusätzliche Langstatorelemente integriert werden, um den Transportweg zu verändern.

Figur 2 zeigt eine Seitenansicht einer erfindungsgemäßen Vorrichtung. Auch hier ist wieder die Zu- und Abführeinheit 2 mit der Haupttransporteinrichtung 42 dargestellt, die eigentliche Behandlungseinheit 4 mit einer Vielzahl von Behandlungseinrichtungen und die Medienversorgungseinheit 6.

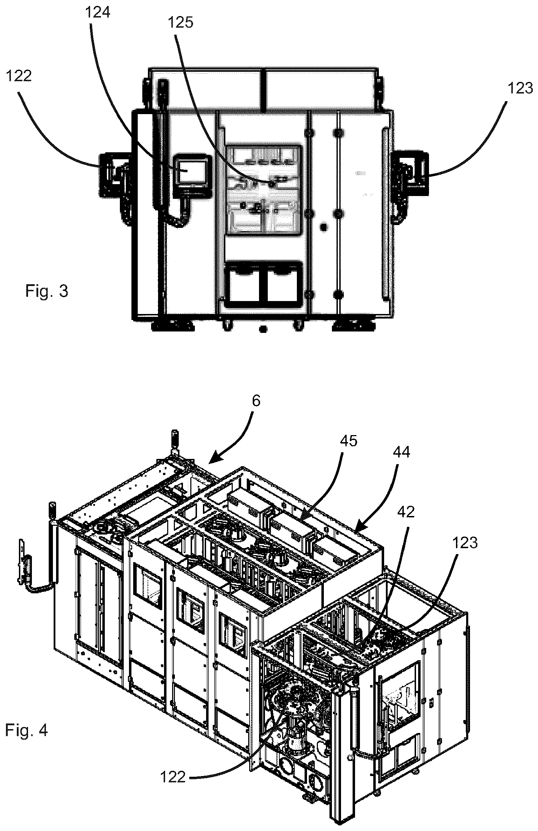

Figur 3 zeigt eine Seitenansicht der erfindungsgemäßen Vorrichtung. Auch hier sind wieder der Zuführstern 122 und der Abführstern 123 erkennbar, sowie auch ein Sichtfenster 125, durch welches der Benutzer den Betrieb der Anlage überwachen kann.

Das Bezugszeichen 124 kennzeichnet eine Bedieneinrichtung, wie etwa einen Touchscreen, um die Vorrichtung zu bedienen.

Figur 4 zeigt eine perspektivische Darstellung einer erfindungsgemäßen Vorrichtung. Auch hier sind wieder der Zuführstern 122 sowie der Abführstern 123 erkennbar, welche die Behältnisse an die Haupttransporteinrichtung 42 übergeben. Man erkennt, dass die Behandlungseinheit 4 mit den einzelnen Behandlungseinrichtungen 44, 45, ... zwischen der Zu- und Abführeinheit 2 und der Medienversorgungseinheit 6 angeordnet ist. Auf diese Weise kann insgesamt eine relativ kompakte Bauweise der gesamten Anlage erreicht werden.

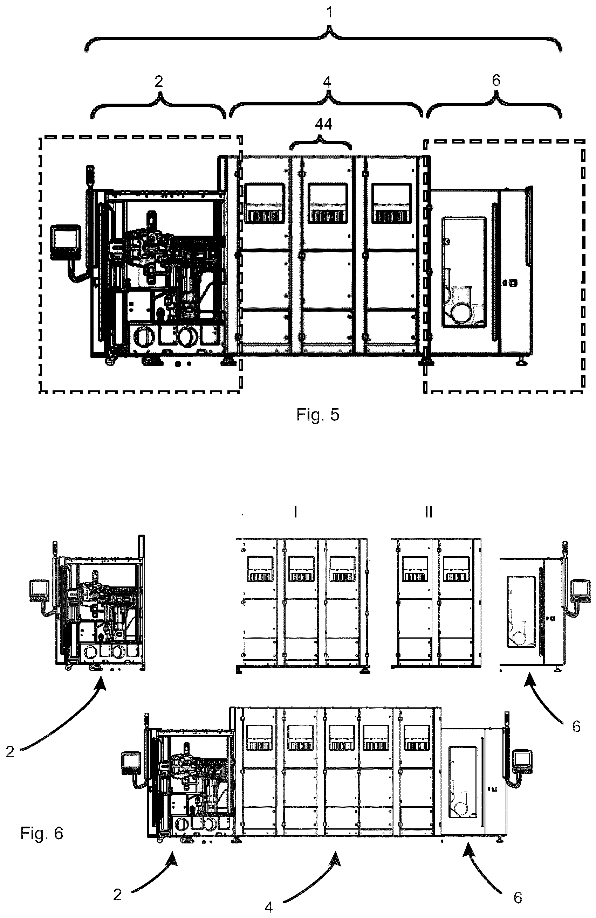

Figur 5 zeigt eine weitere Darstellung der erfindungsgemäßen Vorrichtung 1. Auch hier sind wieder die Segmente der Zu- und Abführeinheit 2, der Behandlungseinheit 4 und der Medienversorgungseinheit 6 zu erkennen. Auch ist hier eine einzelne Behandlungseinrichtung 44 dargestellt. Man erkennt, dass zwischen der Zu- und Abführeinheit 2 und der Medienversorgungseinheit 6 mehrere oder unterschiedliche Anzahlen von Behandlungseinrichtungen 4 eingeführt werden können. Auf diese Weise kann die Anlage beispielsweise erweitert werden.

Figur 6 veranschaulicht diese Situation. Dabei ist hier ein Block I dargestellt, der hier sechs Behandlungseinrichtungen (drei davon nicht sichtbar) aufweist sowie ein zweiter Behandlungsblock 11, der in die Anlage eingeführt werden kann, sodass, wie in dem unteren Teilbild von Figur 6 gezeigt, insgesamt zehn Behandlungseinrichtungen vorgesehen sind. Wie oben erwähnt, ist dabei die Transportlänge der Haupttransporteinrichtung 42 zu verändern.

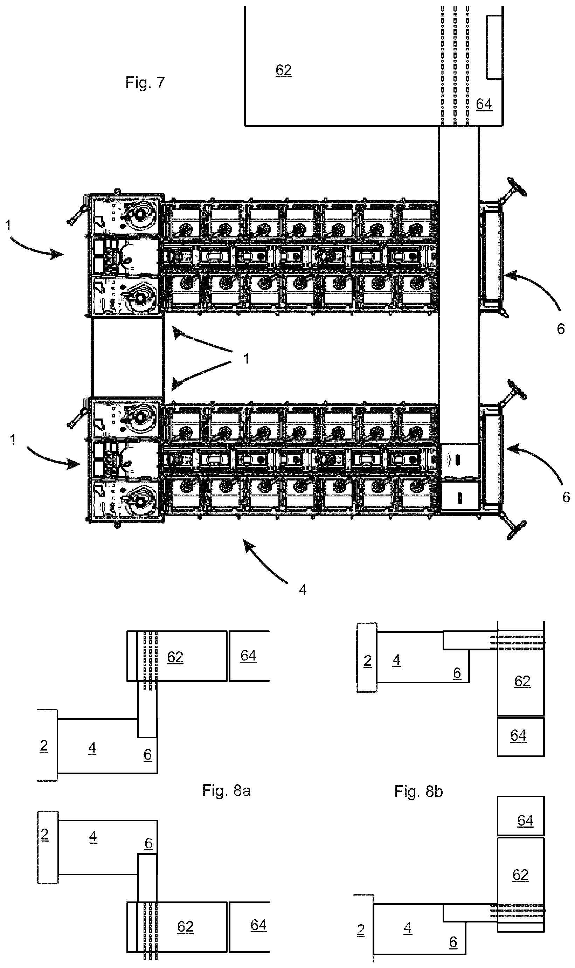

Figur 7 zeigt eine weitere mögliche Anordnung einer erfindungsgemäßen Vorrichtung. Bei dieser Ausgestaltung sind hier zwei Vorrichtungen 1 vorgesehen, welche jeweils eigene Zu- und Abführeinheiten 2 sowie Behandlungseinheiten 4 aufweisen. Auch sind zwei Medienversorgungseinheiten 6 vorgesehen, welche jedoch gemeinsam von den jeweiligen Reservoirs, das heißt den Pumpenständen 62 für das Vakuum und 64, das heißt der Plasmaversorgung, versorgt werden.

Die Figuren 8a bis 8e zeigen unterschiedliche Anordnungen für erfindungsgemäße Vorrichtung. Es wird jedoch darauf hingewiesen, dass die Ausgestaltungen nicht auf die in diesen Figuren dargestellten Möglichkeiten begrenzt sind. Bei der in Figur 8a gezeigten Vorgehensweise sind zwei Vorrichtungen 1 vorgesehen, die jeweils Zu- und Abführeinheiten 2, Behandlungseinheiten 4 und Medienversorgungseinheiten 6 aufweisen. Diese können jedoch von einer gemeinsamen Transporteinrichtung mit Behältnissen versorgt werden, wobei diese gemeinsame Transporteinrichtung auch eine Wendeeinrichtung sein oder aufweisen kann, welche die Behältnisse wendet, beispielsweise zu deren Behandlung mit der Mündung nach unten ausrichtet.

Figur 8b zeigt eine weitere Ausgestaltung, wobei hier die Anordnung der jeweiligen Reservoirs für die Medien modifiziert ist, etwa um eine Anpassung an andere räumliche Gegebenheiten zu erreichen.

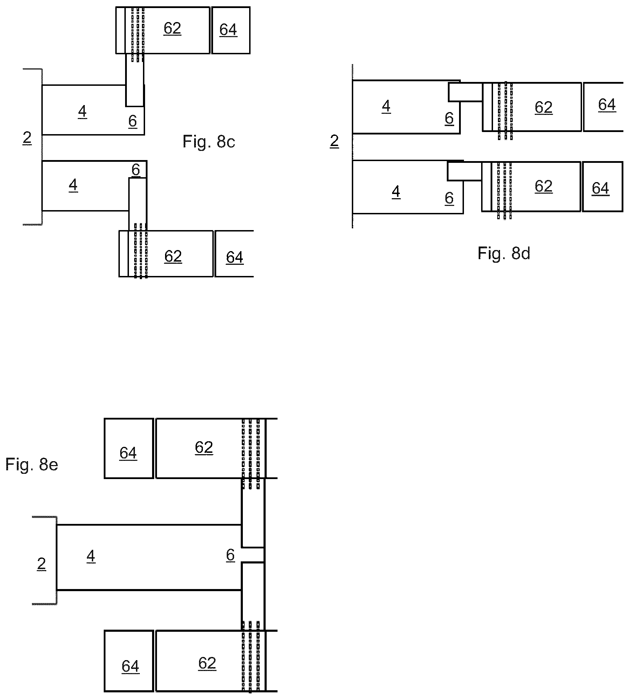

Figur 8c zeigt eine weitere Ausgestaltung einer erfindungsgemäßen Vorrichtung. Bei dieser Ausgestaltung ist eine gemeinsame Zu- und Abführeinheit 2 vorgesehen, welche zwei getrennte Behältnisbehandlungseinheiten 4 versorgt. Daneben sind auch hier zwei Medienversorgungseinheiten 6 vorgesehen.

Bei der in Figur 8d gezeigten Ausführungsform ist ebenfalls eine gemeinsame Zu- und Abführeinheit 2 vorgesehen, die zwei getrennte Behältnisbehandlungseinheiten 4 versorgt. Die räumliche Anordnung ist hier wiederum jedoch modifiziert.

Bei der in Figur 8e gezeigten Ausgestaltung ist eine Zu- und Abführeinheit 2 vorgesehen, welche eine Behandlungseinheit 4 mit einer hohen Anzahl von Behältnisbehandlungseinrichtungen vorsorgt. Aufgrund der hohen Anzahl von Behältnisbehandlungseinrichtungen sind hier zwei Reservoirs bzw. gegebenenfalls auch zwei Medienversorgungseinheiten vorgesehen.

Man erkennt, dass insgesamt die Vorrichtung insbesondere je nach räumlichen Gegebenheiten angepasst werden kann, um eine vom Kunden gewünschte Leistung bzw. einen vom Kunden gewünschten Durchsatz zu erreichen.

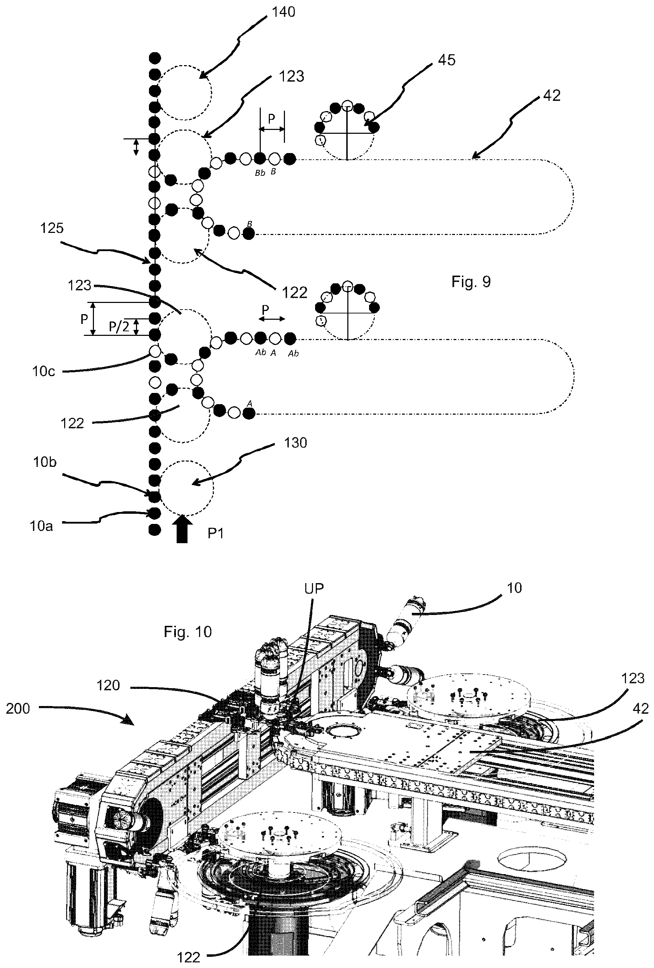

Fig. 9 zeigt eine schematische Darstellung einer Anordnung mit zwei Haupttransporteinrichtungen, die jedoch von einem gemeinsamen Zustrom an Behältnissen 10 (Pfeil P1) versorgt werden.

Dabei werden die Behältnisse abwechselnd den beiden Haupttransporteinrichtungen zugeführt. Dabei kennzeichnet das Bezugszeichen 10a ein Behältnis, welches der unteren Haupttransporteinrichtung 42 zugeführt wird und das Bezugszeichen 10b ein Behältnis, welches der oberen Haupttransporteinrichtung zugeführt wird. Das Bezugszeichen 10c kennzeichnet eine Leerstelle bzw. eine unbesetzte Halteeinrichtung.

Das Bezugszeichen 130 kennzeichnet eine Zuführeinrichtung, um die Behältnisse dem gesamten Behandlungsprozess zuzuführen und das Bezugszeichen 140 eine Abführeinrichtung, um die Behältnisse von dem Prozess abzuführen. Das Bezugszeichen 125 kennzeichnet eine Wendeeinrichtung bzw. eine Wendestrecke, entlang derer die Behältnisse gewendet werden

Fig. 10 zeigt eine Darstellung einer zweiten Transporteinrichtung 200, die auch eine Wendeeinrichtung ist. Zu erkennen ist ein als Teilungsverzugsstern ausgebildeter Einlaufstern 122, der Behältnisse 10 in einer aufrechtstehenden Position an die zweite Transporteinrichtung 200 übergibt. Die Behältnisse werden von der Transporteinrichtung 200 über einen gekrümmten Abschnitt nach oben bewegt. Durch diese Bewegung werden die Behältnisse 10 automatisch gewendet, so dass sie im oberen Bereich der zweiten Transporteinrichtung 200 in einer umgedrehten Position transportiert werden.

Am Übergabepunkt ÜP werden die Behältnisse 10 von der zweiten Transporteinrichtung 200 an die Haupttransporteinrichtung 42 übergeben. Nachdem die Behältnisse 10 die erste Transporteinrichtung 42 umlaufen haben, werden die Behältnisse 10 wieder am Übergabepunkt ÜP an die zweite Transporteinrichtung 200 übergeben. Die Behältnisse 10 befinden sich dabei noch immer in einer umgedrehten Position, da eine solche Position zum Beschichten bevorzugt ist. Nachdem die Behältnisse einen linearen Abschnitt der Transporteinrichtung 200 entlang transportiert wurden, werden sie einen gekrümmten Abschnitt nach unten transportiert, wodurch die Behältnisse 10 wieder automatisch in eine aufrechtstehende Position gewendet werden. Die Behältnisse 10 werden in dieser aufrechtstehenden Position an den Auslaufstern 123, der bevorzugt als Teilungsverzugsstern ausgestaltet ist, übergeben.

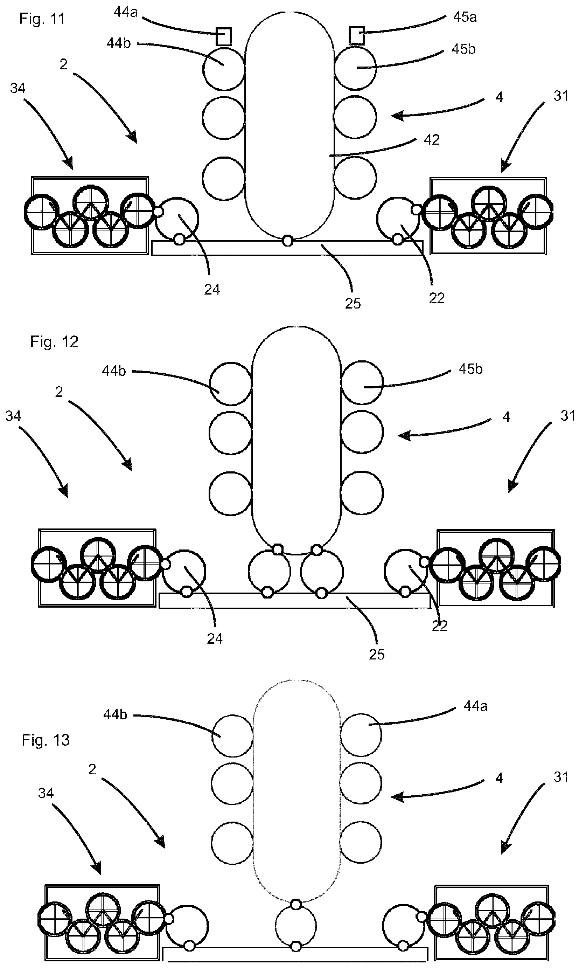

Figur 11 zeigt eine erste Ausgestaltung einer erfindungsgemäßen Behandlungseinrichtung. Die nachfolgenden Figuren werden lediglich in Bezug auf diejenigen Elemente beschrieben, die jeweils von der nun unter Bezugnahme auf Figur 11 beschriebenen Ausgestaltung abweichen.

Die Bezugszeichen 31 und 34 kennzeichnen Transportabschnitte.

Das Bezugszeichen 2 kennzeichnet die Zuführ- und Abführeinheit für die Behältnisse. Diese dient dazu (nicht gezeichnete), Behältnisse der Haupttransporteinrichtung 42 zuzuführen. Dabei beziehen sich die Bezugszeichen 22 und 24 auf Übergabeeinrichtungen, wie beispielsweise Übergabesterne. Das Bezugszeichen 25 kennzeichnet eine Wendeeinrichtung, die beispielsweise in der Art einer Kette ausgeführt sein kann, um die Behältnisse zu wenden, das heißt, insbesondere mit ihrer Mündung nach unten so auszurichten, dass sie in dieser Position an die Haupttransporteinrichtung 42 übergeben werden. Das Bezugszeichen 4 kennzeichnet insgesamt die eine Behandlungseinheit.

Die Bezugszeichen 44 und 45 kennzeichnen zwei Behandlungseinrichtungen, die jeweils wiederum Behandlungsstationen 44a, 45a bzw. Behandlungselemente aufweisen können. Daneben weisen diese Behandlungseinrichtungen jeweils Behandlungstransporteinrichtungen 44b, 45b auf, welche die Behältnisse zu den jeweiligen Behandlungsstationen transportieren.

Bei der in Figur 11 gezeigten Ausführungsform sind die jeweiligen Behandlungsstationen, erfindungsgemäß Beschichtungsmodule, in einem rechten Winkel zu der Transferstrecke, das heißt, der Strecke, entlang derer die Behältnisse durch die Haupttransporteinrichtung 42 transportiert werden, ausgerichtet.

Die Wendestrecke 25 kann, wie oben erwähnt, eine Kette sein und horizontal angeordnet sein. Allerdings ist auch möglich, dass diese Wendestrecke ein Langstator ist und ebenfalls horizontal ausgerichtet ist.

Bei der in Figur 11 gezeigten Ausgestaltung wird in der Mitte der Wendeeinrichtung das Behältnis an der Transferstrecke übergeben.

Figur 12 unterscheidet sich von der Figur 11 dadurch, dass hier zwei Übergabesterne vorgesehen sind, um die Behältnisse an die Haupttransporteinrichtung 42 zu übergeben. Diese Übergabesterne sind hier besonders bevorzugt als Teilungsverzugssterne ausgebildet, das heißt als Transporteinrichtungen, welche dazu geeignet und bestimmt sind, eine Teilung zwischen aufeinander folgenden Kunststoffbehältnissen zu ändern.

Als Wendestrecke wird jedoch auch hier bevorzugt eine Kette verwendet.

Bei der in Figur 13 gezeigten Ausgestaltung ist hier lediglich ein Übergabestern in der Mitte vorgesehen, um die Behältnisse von der Wendeeinrichtung an die Haupttransporteinrichtung 42 zu übergeben.

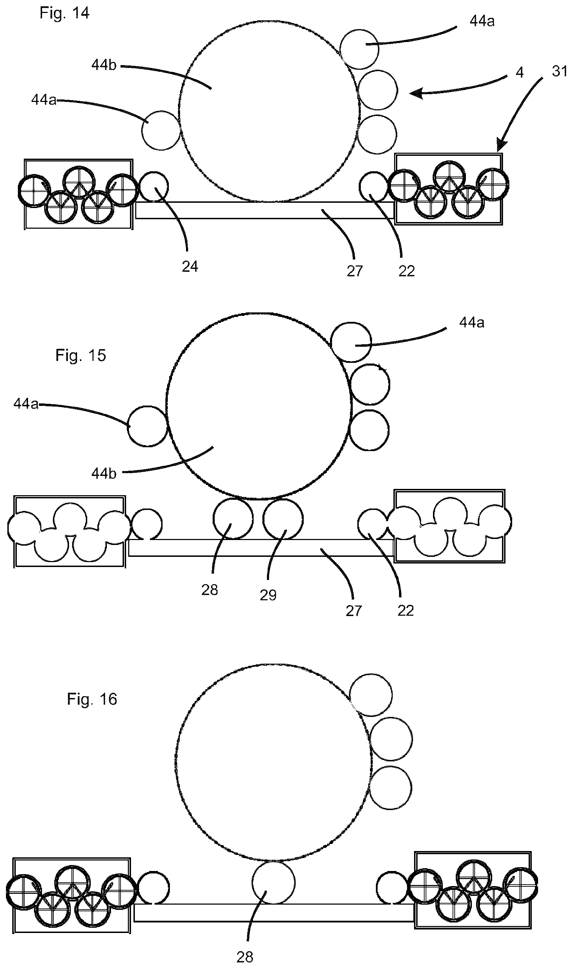

Bei der in Figur 14 gezeigten Ausgestaltung sind auch hier wieder die Beschichtungsmodule im rechten Winkel zur Wendestrecke angeordnet und hier sind kreisförmig die Beschichtungsmodule um die Transferstrecke angeordnet. Bei der Behältnistransporteinrichtung 44b handelt es sich hier um ein Transportrad.

Bei der in Figur 14 gezeigten Ausgestaltung werden die Behältnisse direkt von der Wendestrecke an das Transportrad übergeben. Bei der in Figur 15 gezeigten Ausgestaltung sind wiederum zwei Übergabesterne 28, 29 vorgesehen und bei der in Figur 16 gezeigten Ausgestaltung ein Übergabestern 28.

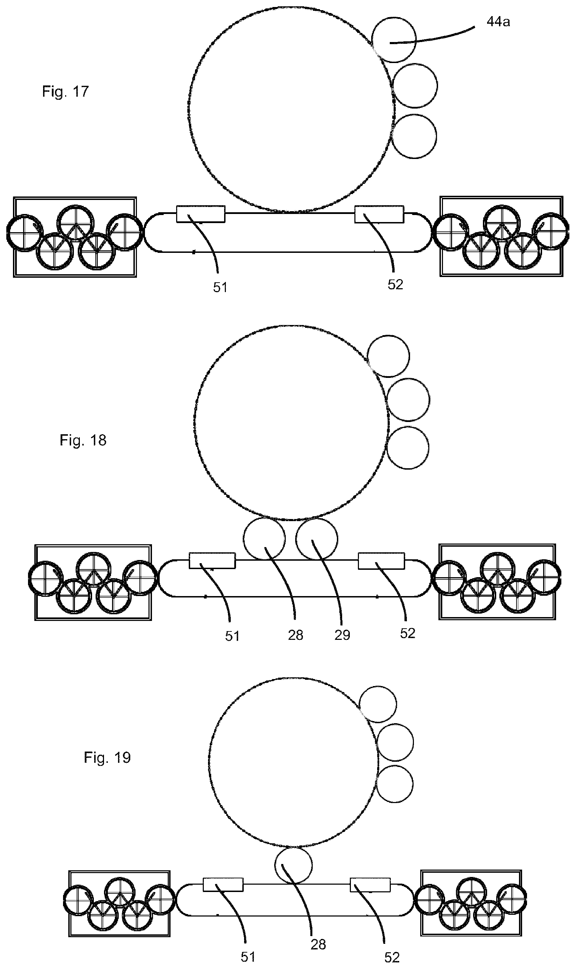

Figur 17 zeigt eine Ausgestaltung, bei der ebenfalls das Beschichtungsmodul im rechten Winkel zu der Transferstrecke angeordnet ist und hier wiederum mittig eine Übergabe der Behältnisse erfolgt.

Bei dieser Ausgestaltung sind zwei Wendeeinrichtungen 51 und 52 vorgesehen, die zunächst die Behältnisse so drehen, dass sie von der Behandlungseinrichtung behandelt werden können und anschließend wieder zurückdrehen, das heißt in eine Position, der die Mündung nach oben ragt.

Die in Figur 18 gezeigte Ausführungsform beschreibt einen ähnlichen Sachverhalt, jedoch hier mit zwei Übergabesternen, und die Figur 19 zeigt lediglich einen Übergabestern.

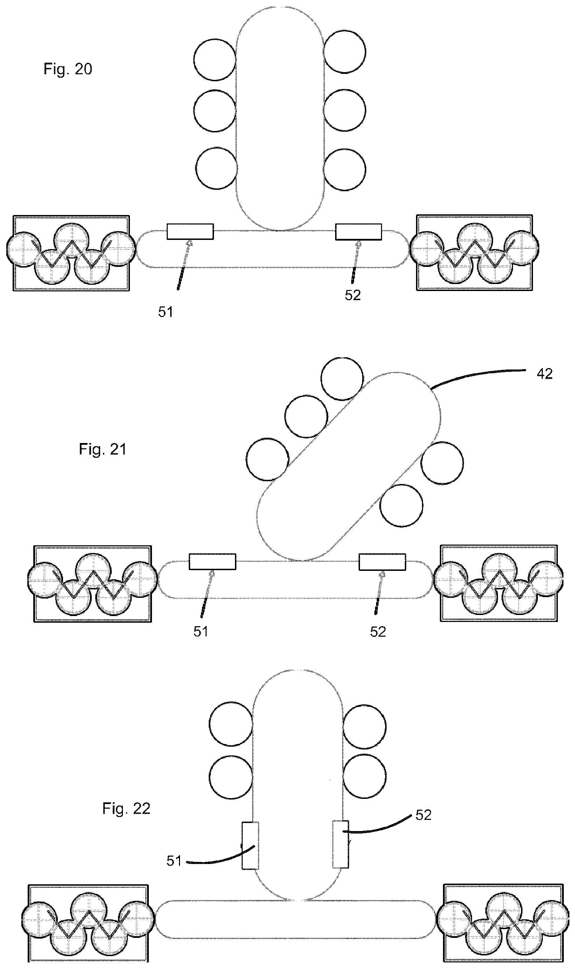

Auch bei den Figuren 20 bis 22 sind wiederum zwei Wendevorrichtungen 51, 52 vorgesehen. Die Haupttransporteinrichtung ist jedoch bei der in Figur 21 gezeigten Ausgestaltung schräg angeordnet. Bei der in Figur 22 gezeigten Ausgestaltung befinden sich die Wendevorrichtung 51, 52 in dem Bereich der Haupttransporteinrichtung 42.

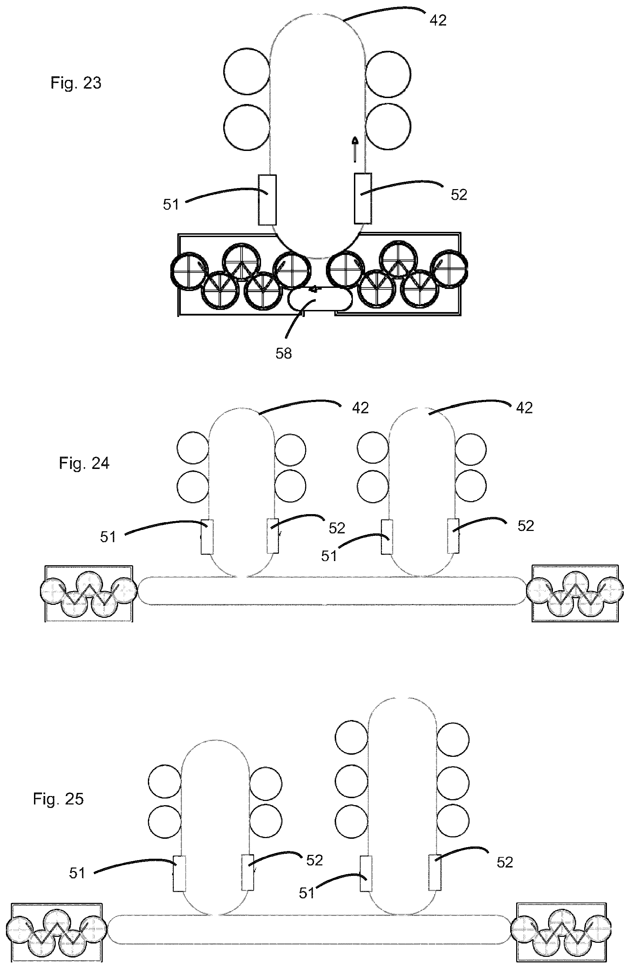

Bei der in Figur 23 gezeigten Ausgestaltung werden die Behältnisse auf der Transferstrecke bzw. der Haupttransporteinrichtung 42 gewendet und vor der Station S1 und nach der Station Sn werden die Behältnisse wieder in die Ausgangsposition zurückgewendet.

Auch kann es ich bei der Transferstrecke bzw. der Haupttransporteinrichtung um ein Kettenrad und/oder einen Langstator handeln. Bei dieser Ausgestaltung werden die Behältnisse in einem Bogen der Transferstrecke übergeben und die Behältnisse werden von der Transportstrecke in einem Bogen übernommen. Zusätzlich ist bei der hier gezeigten Ausgestaltung eine Beipasseinrichtung 58 vorgesehen, mit der es möglich ist, die Behandlungseinrichtung 4 zu umgehen.

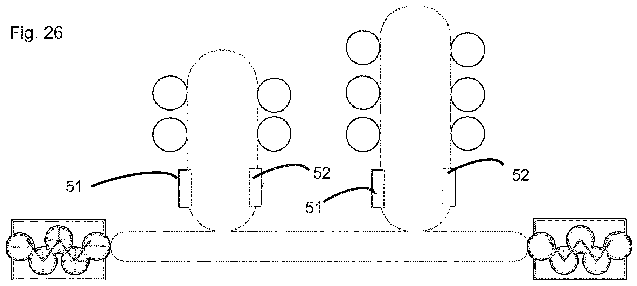

Bei den in den Figuren 24 - 26 gezeigten Situation sind jeweils zwei Behandlungseinrichtungen dargestellt, die bezüglich des Transportpfads der Behältnisse in Serie angeordnet sind.

### Bezugszeichenliste

- 1: Vorrichtung
- 2: Zu- und Abführeinheit
- 4: Behältnisbehandlungseinheit
- 6: Medienversorgungseinheit
- 28: Übergabestern
- 29: Übergabestern
- 31: Transportabschnitt
- 34: Transportabschnitt
- 42: Haupttransporteinrichtung
- 42: Reservoir
- 44: Behandlungseinrichtung
- 44a: Behandlungsstation
- 44b: Behältnistransporteinrichtung
- 45: Behandlungseinrichtung
- 45a: Behandlungsstation
- 45b: Behältnistransporteinrichtung
- 46: Behandlungseinrichtung
- 51: Wendeeinrichtung
- 52: Wendeeinrichtung
- 62: Vakuumpumpenstand
- 64: Chemikalienstand
- 64: Reservoir
- 122: erster Transportstern, Zuführstern
- 123: zweiter Transportstern, Abführstern
- 124: Bedieneinrichtung
- 125: Sichtfenster

## Patentansprüche

1. Vorrichtung (1) zum Beschichten von Behältnissen und insbesondere Kunststoffbehältnissen (10), mit einer Behältnisbehandlungseinheit (4), wobei die Vorrichtung (1) eine Haupttransporteinrichtung (42) aufweist, welche dazu geeignet und bestimmt ist, die Behältnisse (10) entlang eines vorgegebenen Transtransportpfads (P) zu transportieren, wobei die Behältnisbehandlungseinheit (4) wenigstens zwei Beschichtungseinrichtungen (44, 45, 46) zum Beschichten von Innenwandungen der Behältnisse aufweist, welche dazu geeignet und bestimmt sind, die Behältnisse (10) in einer vorgegebenen Weise zu beschichten, mit einer Zuführ- und Abführeinheit (2), welche dazu geeignet und bestimmt ist, wenigstens der ersten Behandlungseinheit (4) zu behandelnde Behältnisse zuzuführen und von der ersten Behandlungseinheit (4) behandelte Behältnisse (10) abzuführen und mit einer Medienversorgungseinheit (6), welche dazu geeignet und bestimmt ist, der wenigstens einen ersten Behandlungseinheit (4) Medien zuzuführen,
**dadurch gekennzeichnet, dass**
die Vorrichtung (1) modular aufgebaut und/oder beliebig erweiterbar ist, derart dass wenigstens eine weitere Behältnisbeschichtungseinrichtung (44, 45, 46) hinzufügbar ist, wobei die Beschichtungseinrichtungen (44, 45, 46) jeweils eine Behandlungstransporteinrichtung (44b, 45b, 46b) aufweisen, welche dazu geeignet und bestimmt ist, die Behältnisse (10) entlang eines vorgegebenen Transtransportpfads zu transportieren, und eine Vielzahl von Beschichtungsmodulen (44a, 45a), welche dazu geeignet und bestimmt sind, die Behältnisse (10) in der vorgegebenen Weise zu beschichten, wobei die Behandlungstransporteinrichtungen (44b, 45b, 46b) die Behältnisse (10) in die jeweiligen Beschichtungsmodule (44a, 45a) transportieren, und
die Vorrichtung (1) eine Behälterwendeeinrichtung (125) aufweist, die dazu geeignet und bestimmt ist, die zu transportierenden Behältnisse zu wenden, so dass der Zu- und Abführeinheit (2) die Behältnisse mit ihrer Mündung nach oben zugeführt werden, jedoch der eigentliche Beschichtungsvorgang in einem gewendeten Zustand der Behältnisse, in dem die Mündung der Behältnisse nach unten ragt erfolgt.

2. Vorrichtung (1) nach Anspruch 1,
**dadurch gekennzeichnet, dass**
die Zu- und Abführeinheit (2) auch dazu geeignet und bestimmt ist, der weiteren Beschichtungseinrichtung (44, 45, 46) zu beschichtende Behältnisse zuzuführen und von der weiteren Beschichtungseinrichtung (44, 45, 46) beschichtete Behältnisse (10) abzuführen und/oder die Medienversorgungseinheit (6) dazu geeignet und bestimmt ist, der weiteren Beschichtungseinrichtung (44, 45, 46) Medien zuzuführen.

3. Vorrichtung (1) nach wenigstens einem der vorangegangenen Ansprüche,
**dadurch gekennzeichnet, dass**
die Behältnisbeschichtungseinrichtungen (44, 45, 46) bezüglich eines Transportpfads der Behältnisse in Serie und/oder parallel geschalten sind.

4. Vorrichtung (1) nach wenigstens einem der vorangegangenen Ansprüche,
**dadurch gekennzeichnet, dass**
die Behältnisbeschichtungseinrichtung (44, 45) eine Behandlungstransporteinrichtung (44b, 45b) aufweist, welche die Behältnisse transportieren und wobei die Behältnisse (10) von der Haupttransporteinrichtung (42) an eine und insbesondere genau eine der Beschichtungseinrichtungen (44, 45) zum Zwecke der Beschichtung durch die Beschichtungseinrichtung (44, 45) übergebbar sind und die Behältnisse insbesondere nach deren Beschichtung durch die Beschichtungseinrichtung (44, 45) wieder an die Haupttransporteinrichtung (42) übergebbar sind.

5. Vorrichtung (1) nach wenigstens einem der vorangegangenen Ansprüche,
**dadurch gekennzeichnet, dass**
die Vorrichtung eine Teilungsänderungseinrichtung aufweist, welche dazu geeignet und bestimmt ist, einen Abstand zweier in der Transportrichtung hintereinander angeordneter Behältnisse zu verändern.

6. Vorrichtung (1) nach wenigstens einem der vorangegangenen Ansprüche,
**dadurch gekennzeichnet, dass**
wenigstens eine Beschichtungseinrichtung (44, 45) senkrecht bezüglich eines Transportpfades der Behältnisse angeordnet ist.

7. Vorrichtung (1) nach wenigstens einem der vorangegangenen Ansprüche,
**dadurch gekennzeichnet, dass**
wenigstens eine Transporteinrichtung und insbesondere die Haupttransporteinrichtung die Behältnisse wenigstens abschnittsweise entlang eines Transportpfades transportiert, der einen von einem kreissegmentförmigen Verlauf abweichenden Verlauf hat.

8. Vorrichtung (1) nach wenigstens einem der vorangegangenen Ansprüche,
**dadurch gekennzeichnet, dass**
wenigstens eine Transporteinrichtung ein umlaufendes Transportmittel und insbesondere eine Transportkette oder einen Langstator aufweist.

9. Vorrichtung (1) nach wenigstens einem der vorangegangenen Ansprüche,
**dadurch gekennzeichnet, dass**
die Haupttransporteinrichtung (42) segmentiert aufgebaut ist und/oder hinsichtlich ihrer Aufnahmekapazität für Behältnisse veränderbar ist.

## Claims

1. Apparatus (1) for coating containers and in particular plastic containers (10) having a container treatment unit (4), wherein the apparatus (1) has a main transport device (42) which is suitable and intended to transport the containers (10) along a predetermined transport path (P), wherein the container treatment unit (4) has at least two coating devices (44, 45, 46) for coating inner walls of the containers, which are suitable and intended to coat the containers (10) in a predetermined manner, having a feed and discharge unit (2) which is suitable and intended to feed containers to be treated to at least the first treatment unit (4) and to discharge containers (10) already treated from the first treatment unit (4) and having a media supply unit (6) which is suitable and intended to feed media to the at least one first treatment unit (4),
**characterized in that**
the apparatus (1) is modular and/or freely expandable in such a way that at least one further container coating device (44, 45, 46) can be added wherein the coating devices (44, 45, 46) each have a treatment transport device (44b, 45b, 46b) which is suitable and intended to transport the containers (10) along a predetermined transport path having a plurality of coating modules (44a, 45a) which are suitable and intended to coat the containers in the predetermined manner wherein the treatment transport devices (44b, 45b, 46b) transport the containers (10) to the respective coating modules (44a, 45a), and
the apparatus (1) has a container turning device (125), which is suitable and intended to turn the containers to be transported such that the containers are fed to the feed and discharge unit (2) with their mouth upwards, but the actual coating process takes place in a turned state of the containers, in which the mouth of the containers protrude downwards.

2. Apparatus according to claim 1,
**characterized in that**
the feed and discharge unit (2) is also suitable and intended to feed containers to be coated to the further coating device (44, 45, 46) and to discharge already coated containers (10) from the further coating device (44, 45, 46) and/or the media supply unit (6) is suitable and intended to feed media to the further coating device (44, 45, 46).

3. Apparatus (1) according to at least one of the preceding claims,
**characterized in that**
the container coating devices (44, 45, 46) are connected in series and/or in parallel relative to the transport path of the containers.

4. Apparatus (1) according to at least one of the preceding claims,
**characterized in that**
the container coating device (44, 45) has a treatment transport device (44b, 45b) which transports the containers and wherein the containers (10) are able to be handed over from the main transport device (42) to one and in particular to precisely only one of the coating devices (44, 45) for the purpose of coating by the coating device (44, 45) and the containers are able to be handed over to the main transport device (42) again, in particular after being coated by the coating device (44, 45).

5. Apparatus (1) according to at least one of the preceding claims,
**characterized in that**
the apparatus has a pitch changing device which is suitable and intended to change a pitch of two containers being arranged one after the other in the transport direction.

6. Apparatus (1) according to at least one of the preceding claims,
**characterized in that**
at least one coating device (44, 45) is arranged to be perpendicular relative to the transport path of the containers.

7. Apparatus (1) according to at least one of the preceding claims,
**characterized in that**
at least one transport device and in particular the main transport device transports the containers at least sectionally along a transport path which has a course which deviates from a circular segment-shaped course.

8. Apparatus (1) according to at least one of the preceding claims,
**characterized in that**
at least one transport device has a circulating transport means and in particular a transport chain or a long stator.

9. Apparatus (1) according to at least one of the preceding claims,
**characterized in that**
the main transport device (42) is designed to be segmented and/or is able to be changed with respect to its receiving capacity of containers.

## Revendications

1. Dispositif (1) destiné à revêtir des récipients et en particulier des récipients en matière plastique (10), avec une unité de manipulation de récipient (4), dans lequel le dispositif (1) présente un système de transport principal (42), lequel est adapté pour et se destine à transporter les récipients (10) le long d'un trajet de transport (P) prédéfini, dans lequel l'unité de manipulation de récipient (4) présente au moins deux systèmes de revêtement (44, 45, 46) destinés à revêtir des parois des récipients, lesquels sont adaptés pour et se destinent à revêtir d'une manière prédéfinie les récipients (10), avec une unité d'amenée et d'évacuation (2), laquelle est adaptée pour et se destine à amener des récipients à traiter au moins à la première unité de traitement (4) et à évacuer des récipients (10) traités de la première unité de traitement (4), et avec une unité d'alimentation en milieux (6), laquelle est adaptée pour et se destine à amener des milieux à l'au moins une première unité de traitement (4),
**caractérisé en ce que**
le dispositif (1) est élaboré de manière modulaire et/ou est extensible de manière quelconque de telle manière qu'au moins un autre système de revêtement de récipient (44, 45, 46) peut être ajouté, dans lequel les systémes de revêtement (44, 45, 46) présentent un système de transport de manipulation (44b, 45b, 46b), lequel est adapté pour et se destine à transporter les récipients (10) le long d'un trajet de transport prédéfini, et une pluralité de modules de revêtement (44a, 45a), lesquels sont adaptés pour et se destinent à revêtir de la manière prédéfinie les récipients (10),
dans lequel les systèmes de transport de manipulation (44b, 45b, 46b) transportent les récipients (10) vers les modules de revêtements (44a, 45a), et
le dispositif (1) présente un système de retournement de récipient (125), lequel est adapté pour et se destine à retourner les récipients à transporter, de telle sorte que les récipeients soient amenés vers l'unité d'amenée et d'évacuation (2) avec leur ouverture vers le haut, le processus de revêtement propement dit se déroulant pourtant dans un état retourné des récipients, dans lequel l'ouverture des récipients pointe vers le bas.

2. Dispositif (1) selon la revendication 1,
**caractérisé en ce que**
l'unité d'amenée et d'évacuation (2) est également adaptée pour et se destine à amener des récipients à revêtir à l'autre système de revêtement (44, 45, 46) et à évacuer des récipients (10) revêtus de l'autre système de revêtement (44, 45, 46) et/ou l'unité d'alimentation en milieux (6) est adaptée pour et se destine à amener des milieux à l'autre système de revêtement (44, 45, 46).

3. Dispositif (1) selon au moins l'une quelconque des revendications précédentes,
**caractérisé en ce que**
les systèmes de revêtement de récipient (44, 45, 46) sont montés en série et/ou en parallèle par rapport à un trajet de transport des récipients.

4. Dispositif (1) selon au moins l'une quelconque des revendications précédentes,
**caractérisé en ce que**
le système de revêtement de récipient (44, 45) présente un système de transport de manipulation (44b, 45b), lequel transporte les récipients, et dans lequel les récipients (10) peuvent être transférés par le système de transport principal (42) à l'un et en particulier précisément à un des systèmes de revêtement (44, 45) aux fins du revêtement par le système de revêtement (44, 45) et les récipients peuvent être transférés à nouveau au système de transport principal (42) en particulier après leur revêtement par le système de revêtement (44, 45).

5. Dispositif (1) selon au moins l'une quelconque des revendications précédentes,
**caractérisé en ce que**
le dispositif présente un système de changement de séparation, lequel est adapté pour et se destine à modifier un espacement entre deux récipients disposés l'un derrière l'autre dans la direction de transport.

6. Dispositif (1) selon au moins l'une quelconque des revendications précédentes,
**caractérisé en ce que**
au moins un système de revêtement (44, 45) est disposé de manière perpendiculaire par rapport à un trajet de transport des récipients.

7. Dispositif (1) selon au moins l'une quelconque des revendications précédentes,
**caractérisé en ce que**
au moins un système de transport et en particulier le système de transport principal transporte les récipients au moins par endroits le long d'un trajet de transport, qui présente un tracé divergeant d'un tracé en forme de segment de cercle.

8. Dispositif (1) selon au moins l'une quelconque des revendications précédentes,
**caractérisé en ce que**
au moins un système de transport présente un moyen de transport périphérique et en particulier une chaîne de transport ou un stator longitudinal.

9. Dispositif (1) selon au moins l'une quelconque des revendications précédentes,
**caractérisé en ce que**
le système de transport principal (42) est élaboré de manière segmentée et/ou peut être modifié eu égard à sa capacité de réception pour des récipients.
